(19) Europäisches Patentamt

European Patent Office

Office européen des brevets

(11) **EP 4 576 568 A1**

(12) **EUROPEAN PATENT APPLICATION**

(43) Date of publication:
**25.06.2025 Bulletin 2025/26**

(21) Application number: **23219084.3**

(22) Date of filing: **21.12.2023**

(51) International Patent Classification (IPC):
**H03F 1/02** (2006.01)    **H03F 3/30** (2006.01)
**H03F 1/30** (2006.01)    **H03F 1/32** (2006.01)
**H03K 19/0185** (2006.01)    **G05F 3/20** (2006.01)

(52) Cooperative Patent Classification (CPC):
**H03F 1/0211; G05F 3/205; H03F 1/0261;
H03F 1/301; H03F 1/307; H03F 1/3205;
H03F 3/3022; H03K 19/00384; H03F 2200/453**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Stichting IMEC Nederland
5656 AE Eindhoven (NL)**

(72) Inventors:
• **Bhat, Anoop
5508 VD Veldhoven (NL)**
• **Xu, Zule
5643 RR Eindhoven (NL)**

(74) Representative: **Körfer, Thomas
Mitscherlich PartmbB
Patent- und Rechtsanwälte
Karlstraße 7
80333 München (DE)**

(54) **SYSTEM AND METHOD FOR INCREASING TRANSCONDUCTANCE OF A CMOS INVERTER**

(57)    A system (100) is provided for increasing the transconductance of a CMOS inverter (101). The system comprises a biasing circuit (102) configured to provide a supply voltage (Vd) to the CMOS inverter (101), wherein the biasing circuit (102) comprises at least one transistor arrangement, wherein the transistor arrangement and the CMOS inverter (101) are interconnected via back gates of respective transistors. The system further comprises a control circuit (103) configured to provide a bias voltage (Vbg) to the interconnected back gates when the supply voltage (Vd) reaches to a threshold value (Vt), whereby both the biasing circuit (102) and the control circuit (103) together control the transconductance of the CMOS inverter (101) .

Fig. 1

EP 4 576 568 A1

**Description**

Field of the Application

The invention relates to the enhancement of the performance of inverter-based circuits, especially to the enhancement of the transconductance range of the Complementary Metal-Oxide Semiconductor (CMOS) inverter of the inverter-based circuits.

Background of the Application

Radio frequency (RF) receivers may include many inverter-based circuits, such as Low-Noise Transconductance Amplifiers (LNTAs), Transimpedance Amplifiers (TIAs), LowPass Filters (LPFs), to reduce the overall power and to increase the linearity. For instance, the transconductance of the inverters of the inverter-based circuits may be controlled across the temperature and supply voltage variations in order to achieve an optimal performance.

For example, the document Jansen et al., Complementary constant-gm biasing of Nauta-transconductors in low-power Gm-C filters to +/-2% accuracy over temperature, Pages 466-469, 2012 Proceedings of the ESSCIRC, 2013, doi: 10.1109/JSSC.2013.2253233 discloses a static complementary constant-transconductance biasing circuit for CMOS inverter-based filters. However, the transconductance range of the CMOS inverter is limited by the supply voltage of the CMOS inverter.

Object of the Application

Accordingly, an object of the invention is to provide a system and a method for increasing the transconductance range of a CMOS inverter, especially beyond the typical supply voltage of the CMOS inverter.

Solution and advantages

The object is solved by the features of the first independent claim for the system and by the features of the second independent claim for the method. The dependent claims contain further developments.

According to a first aspect of the invention, a system is provided for increasing the transconductance of a CMOS inverter. The system comprises a biasing circuit configured to provide a supply voltage to the CMOS inverter, wherein the biasing circuit comprises at least one transistor arrangement, wherein the transistor arrangement and the CMOS inverter are interconnected via back gates of respective transistors.

In addition, the system comprises a control circuit configured to provide a bias voltage to the interconnected back gates when the supply voltage reaches to a threshold value, whereby both the biasing circuit and the control circuit together control the transconductance of the CMOS inverter.

Advantageously, the transconductance range of the CMOS inverter can be extended beyond the range provided by the supply voltage by the application of the bias voltage at the interconnected back gates of the respective transistors. Furthermore, the control circuit may facilitate an automatic control of the transconductance of the CMOS inverter over the extended transconductance range of the CMOS inverter.

Preferably, the control circuit is further configured to maintain the supply voltage to the CMOS inverter when the supply voltage is higher than the threshold value. This may automatically increase the transconductance range while having control on the transconductance of the CMOS inverter.

Preferably, the transistor arrangement comprises at least one replicated CMOS inverter corresponding to a scaled version of the CMOS inverter and at least one resistor, especially a tunable resistor, operably connected to the replicated CMOS inverter.

In this regard, the transistor arrangement is configured to control the transconductance of the CMOS inverter by means of the replicated CMOS inverter and the resistor. Advantageously, for example, the transconductance of the CMOS inverter can be effectively controlled via a resistor value, especially via the tunable resistor, across voltage and temperature in order to compensate for the voltage and temperature variations. For instance, the resistor value may be a known resistor value, which may facilitate an effective tuning of the resistor.

Preferably, the biasing circuit is configured to provide the supply voltage ranging from a predefined minimum value to the threshold value. In this regard, the predefined minimum value is defined based on a minimum linearity criteria of the transconductance of the CMOS inverter.

Additionally or alternatively, the threshold value is defined based on an operation criteria of the transistor arrangement. The operation criteria to define the threshold value may correspond to the maximum supply voltage that can be provided to the CMOS inverter by the biasing circuit. Advantageously, for example, a maximum linearity of the transconductance of the CMOS inverter, especially at the lower range of the transconductance, can be achieved.

Preferably, the transistor arrangement of the biasing circuit is configured to control the transconductance of the CMOS inverter for the supply voltage ranging from the predefined minimum value to the threshold value. In this regard, the transconductance is inversely proportional to the resistor of the transistor arrangement. Advantageously, for example, a maximum possible linearity of the transconductance of the CMOS inverter over the transconductance range can be achieved.

Preferably, the control circuit is configured to provide the bias voltage to the interconnected back gates ranging from zero to a supply voltage of the biasing circuit. Advantageously, for example, a maximum possible supply voltage can be maintained for a given transconductance value of the CMOS inverter.

Preferably, the transistor arrangement of the biasing circuit is configured to control the transconductance of the CMOS inverter for the bias voltage to the interconnected back gates ranging from zero to the supply voltage of the biasing circuit. Advantageously, for example, a maximum possible linearity of the transconductance of the CMOS inverter over the extended transconductance range can be achieved.

Preferably, the control circuit comprises at least one comparator, preferably an operational amplifier comparator, configured to sense the supply voltage from the biasing circuit and further to compare the supply voltage with the threshold value.

In this regard, the comparator is configured to exclusively feed the supply voltage to the transistor arrangement and the CMOS inverter when the supply voltage is lower than the threshold value and to additionally feed the bias voltage to the interconnected back gates of the respective transistors of the transistor arrangement and the CMOS inverter when the supply voltage reaches to the threshold value.

Advantageously, for example, the transconductance range of the CMOS inverter can be increased, which may allow to ensure maximum transconductance even with variations in the voltage and temperature. In other words, the range of the transconductance value that can be controlled over the temperature range and the supply voltage range for every transconductance value can be maximized.

Preferably, the respective transistors of the transistor arrangement and the CMOS inverter are Fully-Depleted Silicon-on-Insulator (FDSOI) transistors.

According to a second aspect of the invention, a method is provided for increasing the transconductance of a CMOS inverter. The method comprises the step of providing, by a biasing circuit, a supply voltage to the CMOS inverter, wherein at least one transistor arrangement of the biasing circuit and the CMOS inverter are interconnected via back gates of respective transistors.

Furthermore, the method comprises the step of providing, by a control circuit, a bias voltage to the interconnected back gates when the supply voltage reaches to a threshold value. Moreover, the method comprises the step of controlling, together by the biasing circuit and the control circuit, the transconductance of the CMOS inverter.

Preferably, the method further comprises the step of maintaining, by the control circuit, the supply voltage to the CMOS inverter when the supply voltage is higher than the threshold value.

Preferably, the method further comprises the steps of providing, by the biasing circuit, the supply voltage ranging from a predefined minimum value to the threshold value, and providing, by the control circuit, the bias voltage to the interconnected back gates ranging from zero to a supply voltage of the biasing circuit.

Preferably, the method further comprises the steps of controlling, by the transistor arrangement, the transconductance of the CMOS inverter for the supply voltage ranging from the predefined minimum value to the threshold value, and controlling, by the transistor arrangement, the transconductance of the CMOS inverter for the bias voltage to the interconnected back gates ranging from zero to the supply voltage of the biasing circuit.

It is to be noted that the method according to the second aspect corresponds to the system according to the first aspect and its implementation forms. Accordingly, the method of the second aspect may have corresponding implementation forms. Further, the method of the second aspect achieves the same advantages and effects as the system of the first aspect and its respective implementation forms.

Drawings

Exemplary embodiments of the invention are now further explained with respect to the drawings by way of example only, and not for limitation. In the drawings:

Fig. 1    shows a first exemplary embodiment of the system according to an aspect of the invention;

Fig. 2    shows an exemplary process flow of the system according to an aspect of the invention;

Fig. 3A    shows an exemplary relationship between the transconductance and the supply of CMOS inverters;

Fig. 3B    shows an exemplary relationship between the transconductance and the supply, and the transconductance and the back gate voltage of the CMOS inverter according to an aspect of the invention;

Fig. 4    shows a second exemplary embodiment of the system according to an aspect of the invention;

Fig. 5    shows an exemplary tuning effect of the resistor on the parameters of the CMOS inverter according to an aspect of the invention; and

Fig. 6    shows an exemplary embodiment of the method according to an aspect of the invention.

Preferred Embodiments

Reference will now be made in detail to the embodiments of the present invention, examples of which are illustrated in the accompanying drawings. However, the following embodiments of the present invention may be variously modified and the range of the present invention is not limited by the following embodiments.

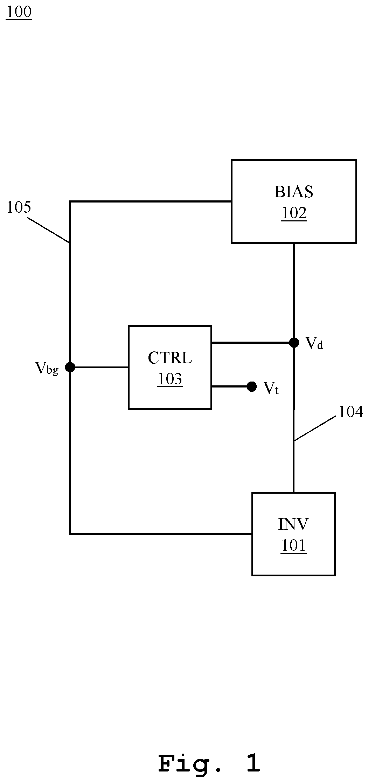

In Fig. 1, a first exemplary embodiment of the system 100 according to the first aspect of the invention is illustrated. The system 100 may control one or more parameters of an inverter 101. It should be noted that the system 100 may comprise the inverter 101 or may act as a stand-alone system operably connected to the inverter 101.

For example, the inverter 101 may correspond to any inverter-based blocks, especially to any inverter-based blocks, such as LNTA, TIAs, LPF, of an RF receiver. For instance, the inverter 101 may comprise one or more FDSOI transistors, especially one FDSOI PMOS transistor and one FDSOI NMOS transistor arranged in a complementary manner.

For example, the system 100 may comprise a biasing circuit 102 connected to the inverter 101 via a supply line 104. The biasing circuit 102 may correspond to a complementary constant-transconductance (Gm) biasing circuit, of which the operation is known in the art. The biasing circuit 102 may provide a supply voltage Vd to the inverter 101, e.g., via the supply line 104. The biasing circuit 102 may comprise at least one transistor arrangement, especially comprising FDSOI transistors, which is not explicitly shown here.

In this regard, the FDSOI transistors of the biasing circuit 102 and the FDSOI transistors of the inverter 101 may be interconnected via back gates of respective transistors, i.e., respective FDSOI PMOS transistors and respective FDSOI NMOS transistors, via a bias line 105.

For example, the system 100 may comprise a control circuit 103 connected to the supply line 104 and further to the bias line 105. The control circuit 103 may continuously sense or monitor the supply voltage Vd at the supply line, and may compare the supply voltage Vd with a threshold voltage Vt.

It is to be noted that the threshold voltage Vt may be internally generated by the control circuit 103. Alternatively, the threshold voltage Vt may be externally fed to the control circuit 103, e.g., from an external signal generation unit connected to the control circuit 103.

It is to be noted that, in the following, the implementation regarding back gate biasing (e.g., via a back gate bias voltage Vbg) is illustrated for the NMOS transistor of the CMOS inverter 101 for simplicity if not explicitly mentioned otherwise.

For instance, the control circuit 103 may provide the bias voltage Vbg to the interconnected back gates, e.g., via the bias line 105, when the supply voltage Vd becomes equal to the threshold voltage Vt. However, if the supply voltage Vd is less than the threshold voltage Vt, the control circuit 103 may maintain the supply voltage Vd and may set the bias voltage Vbg to zero.

Accordingly, the control circuit 103 may additionally feed the bias voltage Vbg to the interconnected back gates of the respective FDSOI transistors of the biasing circuit 102 and the inverter 101 when the supply voltage Vd becomes equal to the threshold voltage Vt, while maintaining the supply voltage Vd to the FDSOI transistors of the biasing circuit 102 and of the inverter 101.

As such, the bias circuit 102 and the control circuit 103 may collectively control the Gm range of the inverter 101, especially to increase the Gm range beyond the range limited by the supply voltage Vd, by means of the additional bias voltage Vbg at the interconnected back gates of the respective FDSOI transistors.

Furthermore, by means of the constant sensing and comparison of the supply voltage Vd with the threshold voltage Vt, the control circuit 103 may provide an automatic control of the Gm of the inverter 101 over the extended Gm range of the inverter 101.

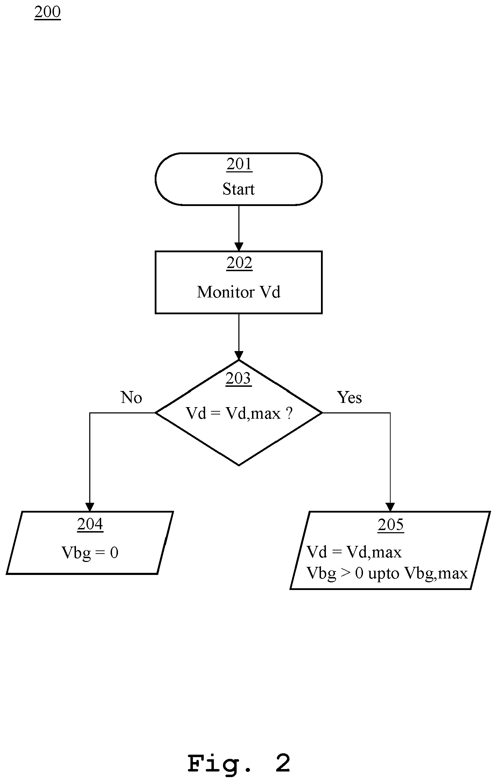

In Fig. 2, an exemplary algorithm 200 of the system 100 is illustrated via a process flow diagram. It is to be noted that, for simplicity, the implementation regarding the bias voltage Vbg is illustrated for the NMOS transistor of the CMOS inverter 101.

For example, during the initiation phase 201, the biasing circuit 102 may supply the supply voltage Vd to the inverter 101 and further to the inverter arrangement of the biasing circuit 102, especially to ensure the proper operation of the inverter 101. Moreover, the control circuit 103 may be connected to the supply line 104 and further to the bias line 105 that may interconnect the back gates of the respective transistors of the biasing circuit 102 and the inverter 101.

During the monitoring phase 202, which may run along the initiation phase 201, the control circuit 103 may continuously monitor the supply voltage Vd with respect to the threshold voltage Vt.

During the decision phase 203, the control circuit 103 may sense whether the supply voltage Vd is less than the threshold voltage Vt or is equal to the threshold voltage Vt.

If the supply voltage Vd is less than the threshold voltage Vt, the control circuit 103 may only maintain the supply voltage Vd by setting the bias voltage Vbg to zero, thereby resulting a phase 204 of the process flow.

However, if the supply voltage Vd becomes equal to the threshold voltage Vt, the control circuit may maintain the supply voltage Vd and may additionally supply the bias voltage Vbg to the interconnected back gates of the respective transistors, thereby resulting an alternative phase 205 of the process flow.

Therefore, the process flow diagram may result in the following use case scenario in order to maintain a constant transconductance over temperature and supply voltage variations:

a) from the flow 203 to the flow 204, i.e., if the supply voltage Vd is less than the threshold voltage Vt, a constant Gm of the CMOS inverter 101 may be maintained by solely controlling the supply voltage Vd to the CMOS inverter 101 by setting the bias voltage Vbg=0, and
b) from the flow 203 to the flow 205, i.e., if the supply voltage Vd is equal or greater than the threshold voltage Vt, the bias voltage Vbg may be supplied to the interconnected back gates and may be controlled accordingly to maintain a constant Gm of the CMOS inverter 101.

Additionally, the process flow from 203 to 205 may be used for a further scenario that may require an inverter with a Gm, which is higher than the Gm range solely provided by the supply voltage Vd of the inverter.

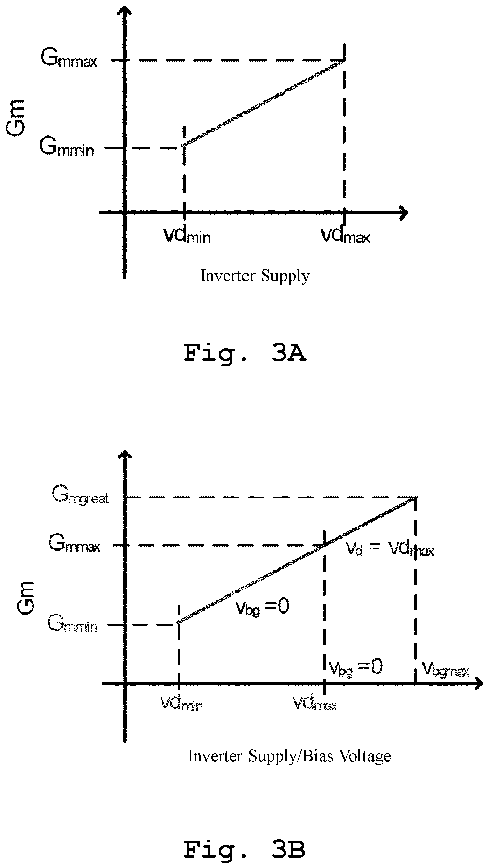

In Fig. 3A, an exemplary relationship between the Gm and the supply of CMOS inverters is illustrated, where the Gm is especially controlled by a conventional complementary constant-Gm biasing circuit.

In particular, the complementary constant-Gm biasing circuit may control the inverter supply voltage such that the Gm of the inverter is inversely proportional to a control resistor of the complementary constant-Gm biasing circuit. Since the resistor value is well known across supply voltage and temperature, the Gm of the inverter can be controlled over the GM range and further maintained constant at a desired GM value by adjusting the resistance value of the control resistor which in turns adjusts the inverter supply accordingly.

Generally, the Gm of the inverter can be expressed as the ratio of the output current to the input voltage of the inverter. In order to achieve a reliable performance, the Gm should be regulated over supply voltage and temperature variation. The control resistor of the complementary constant-Gm biasing circuit may vary the inverter supply in order to determine the Gm of the inverter, where the input and output nodes of the inverter may be unaffected in order not to disturb the signal flow.

Since the control resistor may control the supply voltage of the inverter in order to control the Gm of the inverter, where the Gm may be limited by the inverter supply voltage as well.

Turning back to Fig. 3A, the horizontal axis denotes the inverter supply voltage and the vertical axis denotes the Gm. As it can be seen, the lower side of the Gm, i.e., the Gmmin, is limited by the minimum inverter supply Vdmin in order to satisfy the minimum linearity criteria of for the inverter, whereby the upper side of the Gm, i.e., the Gmmax, is limited by the maximum inverter supply Vdmax. In a conventional setup, the complementary constant-Gm biasing circuit stops being operational after reaching Vdmax.

In Fig. 3B, an exemplary relationship between the Gm and the supply of the inverter 101 is illustrated according to the first aspect of the invention. In order to overcome the limitation of Vdmax on the upper side of the Gm, the back gates of the respective transistors of the biasing circuit 102 and the inverter 101 may be interconnected and may be fed with the bias voltage Vbg by the control circuit 103, thereby extending the inverter supply voltage range.

In Fig. 3B, the horizontal axis denotes the inverter supply voltage Vd and the bias voltage Vbg. The vertical axis denotes the Gm of the inverter 101. It can be seen that, similar to Fig. 3A, the lower side of the Gm, i.e., the Gmmin, is limited is limited by the minimum inverter supply Vdmin in order to satisfy the minimum linearity criteria of for the inverter 101, however, the upper side of the Gm in relation to Fig. 3A, i.e., the Gmmax, is now extended further to Gmgreat, especially due to the application of the bias voltage Vbg to the interconnected back gates while maintaining the supply voltage Vd.

In this regard, as previously described in relation to Fig. 1 and Fig. 2, the biasing circuit 102 may provide the supply voltage Vd to the inverter 101 and the control circuit 103 may continuously sense the supply voltage Vd with respect to the threshold voltage Vt, which is shown here as the maximum inverter supply Vdmax.

In this regard, the control circuit 103 may exclusively maintain the supply voltage Vd to the inverter 101 over the range Vdmin to Vdmax, especially by setting the bias voltage Vbg at the interconnected back gates to zero. When the supply voltage Vd reaches to its highest limit Vdmax, the control circuit 103 may apply the bias voltage Vbg to the interconnected back gates while maintaining the supply voltage Vd at its maximum limit Vdmax.

Accordingly, the Gm of the inverter 101 can be effectively increased from the maximum limit Gmmax of Fig. 3A to a greater limit Gmgreat while simultaneously extending the inverter supply from the maximum limit Vdmax of Fig. 3A to a greater limit Vdmax, which may correspond to the supply voltage of the biasing circuit 102.

It is to be noted that, for simplicity, the increase in the bias voltage Vbg is illustrated for the NMOS transistor of the CMOS inverter 101. It is further to be noted that the linear relationship between the Gm and inverter supply, as shown in Fig. 3A and Fig 3B, are shown only for illustration purpose, and the relationship, e.g., the curve, may be of higher order polynomial.

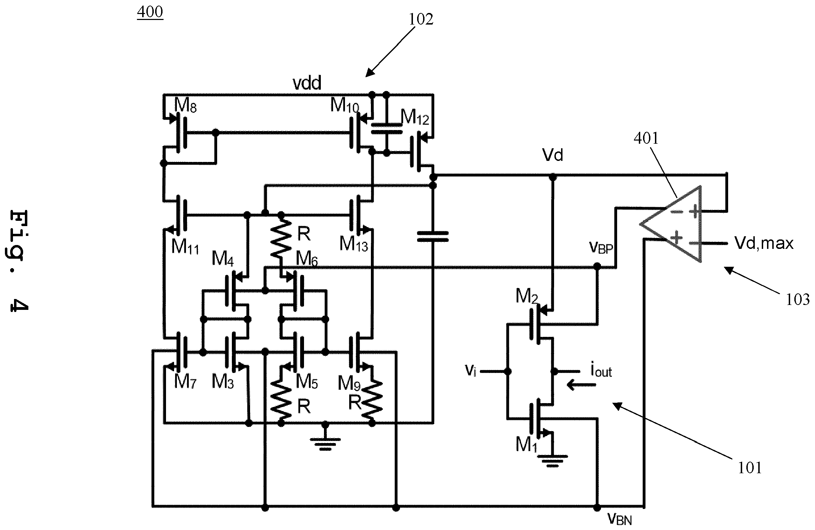

In Fig. 4, a second exemplary embodiment of the system 400 according to the first aspect of the invention is illustrated. In particular, the system 400 exemplarily shows the internal circuital arrangement of the system 100.

For example, the inverter 101 may comprise the complementary FDSOI NMOS M1 and PMOS M2, where Vi may denote the input voltage and iout may denote the output voltage of the inverter 101. As such, the Gm of the inverter 101 can be expressed as:

$$G_m = \frac{i_{out}}{V_i} \tag{1}$$

$$G_m = G_{m,n} + G_{m,p} \tag{2}$$

where $G_{m,n}$ and $G_{m,p}$ are the transconductance of the NMOS M1 and the PMOS M2, respectively.

For a given W/L of the transistors of the inverter 101, the Gm can be expressed as a function of the inverter supply voltage Vd.

The biasing circuit 102 may correspond to a conventional complementary constant-Gm biasing circuit, where the back gates of the respective transistors of the biasing circuit 102 and the inverter 101 are additionally interconnected.

For example, the biasing circuit 102 may regulate the inverter supply voltage Vd such that the Gm of the inverter 101 can be maintained constant. Generally, the biasing circuit 102 may comprise a start-up segment, a current mirror segment, and a control segment.

For instance, the start-up segment of the biasing circuit 102 may comprise a PMOS M12, which may act as the start-up or regulator for the biasing circuit 102 in order to avoid the lower values of the supply vdd of the biasing circuit 102, especially to avoid feeding the lower values of supply voltage Vd to the inverter 101. In addition, the PMOS M12 may enter in triode region for the upper values of the supply voltage Vd to the inverter 101, thereby limiting the inverter supply voltage Vd to Vd,max.

For example, the current mirror segment may comprise any CMOS current mirror arrangement known in the art. For instance, the current mirror branches of the biasing circuit 102 may comprise complementary pairs of PMOS M8 and NMOS M11, and PMOS M10 and NMOS M13 in order to replicate the current from one branch to the other branch.

For example, the control segment of the biasing circuit 102 may comprise a first CMOS block comprising PMOS M4, NMOS M3, and NMOS M7, where the CMOS M3 and M4 pair may be a scaled version of the CMOS M1 and M2 pair of the inverter 101. Additionally, the control segment of the biasing circuit 102 may comprise a second CMOS block comprising PMOS M6, NMOS M5, and NMOS M9, where the CMOS M5 and M6 pair may be a scaled version of the CMOS M1 and M2 pair of the inverter 101.

The term scaled version should be understood as having a proportional W/L ratio of the transistors. Moreover, the first CMOS block and the second CMOS block may be connected to the respective current mirror branches of the biasing circuit 102.

In this regard, the first CMOS block or the second CMOS block may provide the resistive control for controlling the Gm of the inverter 101. In this example, the source terminals of the PMOS m6, the NMOS M5, and the NMOS M9 are connected to the respective supply via a variable or tunable resistor R.

For example, the respective back gates of the transistors of the first CMOS block, the second CMOS block, and the inverter 101 may be interconnected. For instance, the back gates of the PMOS M4, the PMOS M6, and the PMOS M2 may be interconnected. Additionally, the back gates of the NMOS M3, the NMOS M5, the NMOS M7, the NMOS M9, and the NMOS M1 may be interconnected.

For example, the control circuit 103 may comprise or be an OPAMP 401. The non-inverting terminal of the OPAMP 401 may be connected to the inverter supply Vd and the inverting terminal of the OPAMP 401 may be supplied with a reference voltage, namely the threshold voltage Vd,max, such that the OPAMP 401 may compare the supply voltage Vd with the threshold voltage Vd,max.

For instance, the inverting output of the OPAMP 401 may be connected to the interconnected back gates of the PMOS transistors, namely the back gates of the PMOS M2, the PMOS M4, and the PMOS M6. Additionally, the non-inverting output of the OPAMP 401 may be connected to the interconnected back gates of the NMOS transistors, namely the back gates of the NMOS M1, the NMOS M3, the NMOS M5, the NMOS M7, and the NMOS M9.

In this regard, the Gm of the CMOS M3/M4 can be expressed as:

$$G_{m,34} \propto R \qquad\qquad (3)$$

Since the CMOS M3/M4 may be a scaled version of the CMOS M1/M2 of the inverter 101, the Gm of the CMOS M1/M2 can be expressed as:

$$G_{m,12} \propto R \qquad\qquad (4)$$

Accordingly, the resistor R can be varied in order to regulate or to control the $G_{m,12}$, and the resistor R is constant across temperature and supply voltage variations.

In order to regulate the Gm range as well as the supply voltage range of the inverter 101, the OPAMP 401 may continuously sense the supply voltage Vd with respect to the threshold voltage Vd,max. If the supply voltage Vd is less than the threshold voltage Vd,max, the OPAMP 401 may only maintain the supply voltage Vd for the CMOS transistors by disabling the bias voltage to the respective interconnected back gates of the CMOS transistors.

For instance, the OPAMP 401 may set the bias voltage $V_{BP}$ to vdd for the interconnected back gates of the PMOS transistors, namely the back gates of the PMOS M2, the PMOS M4, and the PMOS M6, and may set the bias voltage $V_{BN}$ to zero for the interconnected back gates of the NMOS transistors, namely the back gates of the NMOS M1, the NMOS M3, the NMOS M5, the NMOS M7, and the NMOS M9.

For example, if the supply voltage Vd is greater than the threshold voltage Vd,max, the OPAMP 401 may maintain the respective supply voltage for the CMOS transistors, whereby additionally feeding the bias voltage to the respective interconnected back gates of the CMOS transistors.

For instance, the OPAMP 401 may set the bias voltage $V_{BP}$ to zero for the interconnected back gates of the PMOS transistors, namely the back gates of the PMOS M2, the PMOS M4, and the PMOS M6, and may set the bias voltage $V_{BN}$ to vdd for the interconnected back gates of the NMOS transistors, namely the back gates of the NMOS M1, the NMOS M3, the NMOS M5, the NMOS M7, and the NMOS M9, especially to maintain the PMOS M12 in the saturation region.

The following table exemplarily illustrates the voltage transitions for the bias voltage applied at the interconnected back gates pf the CMOS transistors.

| Vd | $V_{BP}$ | $V_{BN}$ |
|---|---|---|
| <Vd,max | vdd | 0 |
| Slightly more than Vd,max | Transition from vdd to 0 | Transition from 0 to vdd |
| >Vd,max | 0 | vdd |

Accordingly, both the control circuit 103 and biasing circuit 102 may together increase the tuning range of the $G_{m,12}$ of the inverter 101, whereby simultaneously providing the automatic tuning of the $G_{m,12}$ of the inverter 101.

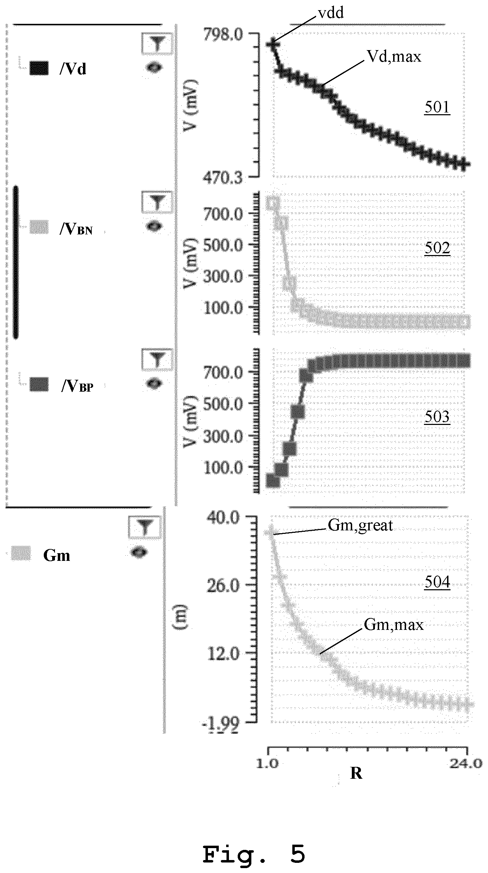

In Fig. 5, an exemplary tuning effect of the resistor R on the parameters of the CMOS inverter 101 is illustrated. The plot 501 illustrates the variation of the inverter supply voltage Vd with the tuning of the resistor R, the plot 502 illustrates the variation of the NMOS back gate bias voltage $V_{BN}$ with the tuning of the resistor R, the plot 503 illustrates the variation of the PMOS back gate bias voltage $V_{BP}$ with the tuning of the resistor R, and finally the plot 504 illustrates the variation of the Gm of the inverter 101 with the tuning of the resistor R.

In the plots 501-504, the voltages are shown in millivolt (mV), the Gm is shown in millisiemens (mS), and the resistance is shown in ohm.

It can be seen that above about 10mS, Vd reaches Vd,max. Therefore, in this example and in relation to Fig. 3B, the Gm,max of the inverter 101 is about 10mS. However, due to the application of the bias voltage to the interconnected back gates of the transistors, the maximum possible supply voltage range of the inverter is extended to vdd, i.e., the supply of the biasing circuit, and the Gm range of the inverter 101 is extended to about 35mS. Accordingly, in this example and in relation to Fig. 3B, the vbg,max is the vdd and the Gm,great is about 35mS.

Furthermore, the transition for the back gate bias voltage $V_{BN}$ from vdd to 0 at the interconnected NMOS transistors is shown in the plot 502. Moreover, the transition for the back gate bias voltage $V_{Bp}$ from 0 to vdd at the interconnected PMOS transistors is shown in the plot 503.

As such, the previous Gm tuning range of 2mS to 10mS of the inverter 101 is successfully extended to achieve a wider Gm tuning range of 2mS to greater than 30mS.

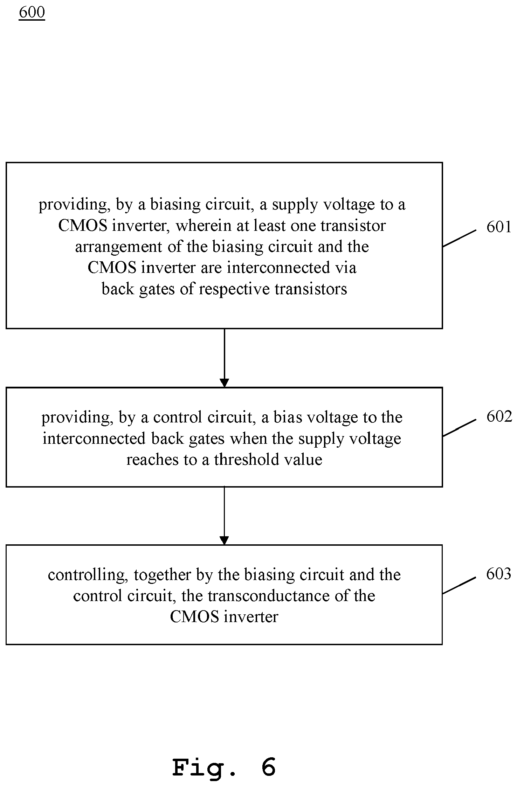

In Fig. 6, an exemplary embodiment of the method 600 according to the second aspect of the invention is illustrated. In a first step 601, a supply voltage is provided to a CMOS inverter by a biasing circuit, where at least one transistor arrangement of the biasing circuit and the CMOS inverter are interconnected via back gates of respective transistors.

In a second step 602, a bias voltage is provided to the interconnected back gates by a control circuit when the supply voltage reaches to a threshold value. In a third step 603, the transconductance of the CMOS inverter is controlled together by the biasing circuit and the control circuit.

It is important to note that, in the description as well as in the claims, the word "comprising" does not exclude other elements or steps and the indefinite article "a" or "an" does not exclude a plurality. A single element or other unit may fulfill the functions of several entities or items recited in the claims.

It should be understood that the term "and/or" used in the specification and the appended claims of this application refers to any combination and all possible combinations of one or more associated listed items, and includes these combinations.

It should also be understood that the word "connected" implies that the elements may be directly connected together or may be coupled through one or more intervening elements. Moreover, the disclosure with regard to any of the aspects is also relevant with regard to the other aspects of the disclosure.

Although the invention has been illustrated and described with respect to one or more implementations, equivalent alterations and modifications will occur to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application.

## Claims

1. A system (100) for increasing the transconductance of a Complementary Metal-Oxide Semiconductor, CMOS, inverter (101), the system comprises:

   a biasing circuit (102) configured to provide a supply voltage (Vd) to the CMOS inverter (101), wherein the biasing circuit (102) comprises at least one transistor arrangement, wherein the transistor arrangement and the CMOS inverter (101) are interconnected via back gates of respective transistors, and
   a control circuit (103) configured to provide a bias voltage (Vbg) to the interconnected back gates when the supply voltage (Vd) reaches to a threshold value (Vt), whereby both the biasing circuit (102) and the control circuit (103) together control the transconductance of the CMOS inverter (101).

2. The system according to claim 1,
   wherein the control circuit (103) is further configured to maintain the supply voltage (Vd) to the CMOS inverter (101) when the supply voltage (Vd) is higher than the threshold value (Vt).

3. The system according to claim 1 or 2,

   wherein the transistor arrangement comprises at least one replicated CMOS inverter ($M_3$, $M_4$, $M_5$, $M_6$) corresponding to a scaled version of the CMOS inverter (101) and at least one resistor (R), especially a tunable resistor, operably connected to the replicated CMOS inverter ($M_3$, $M_4$, $M_5$, $M_6$), and
   wherein the transistor arrangement is configured to control the transconductance of the CMOS inverter (101) by means of the replicated CMOS inverter ($M_3$, $M_4$, $M_5$, $M_6$) and the resistor (R) .

4. The system according to any of claims 1 to 3,
   wherein the biasing circuit (102) is configured to provide the supply voltage (Vd) ranging from a predefined minimum value to the threshold value (Vt).

5. The system according to claim 4,

   wherein the predefined minimum value is defined based on a minimum linearity criteria of the transconductance of the CMOS inverter (101), and/or
   wherein the threshold value (Vt) is defined based on an operation criteria of the transistor arrangement.

6. The system according to claim 4 or 5,

   wherein the transistor arrangement of the biasing circuit (102) is configured to control the transconductance of the CMOS inverter (101) for the supply voltage (Vd) ranging from the predefined minimum value to the threshold value (Vt), and

wherein the transconductance is inversely proportional to the resistor (R) of the transistor arrangement.

7. The system according to any of claims 1 to 6,
   wherein the control circuit (103) is configured to provide the bias voltage (Vbg) to the interconnected back gates ranging from zero to a supply voltage of the biasing circuit (103) .

8. The system according to claim 7,
   wherein the transistor arrangement of the biasing circuit (102) is configured to control the transconductance of the CMOS inverter (101) for the bias voltage (Vbg) to the interconnected back gates ranging from zero to the supply voltage of the biasing circuit (103).

9. The system according to any of claims 1 to 8,
   wherein the control circuit (103) comprises at least one comparator (401), preferably an operational amplifier comparator, configured to sense the supply voltage (Vd) from the biasing circuit (102) and further to compare the supply voltage (Vd) with the threshold value (Vt).

10. The system according to claim 9,
    wherein the comparator (401) is further configured to exclusively feed the supply voltage (Vd) to the transistor arrangement and the CMOS inverter (101) when the supply voltage (Vd) is lower than the threshold value (Vt) and to additionally feed the bias voltage (Vbg) to the interconnected back gates of the respective transistors of the transistor arrangement and the CMOS inverter (101) when the supply voltage (Vd) reaches to the threshold value (Vt).

11. The system according to any of claims 1 to 10,
    wherein the respective transistors of the transistor arrangement and the CMOS inverter (101) are Fully-Depleted Silicon-on-Insulator, FDSOI, transistors.

12. A method (600) for increasing the transconductance of a complementary metal oxide semiconductor, CMOS, inverter, the method comprises:

    providing (601), by a biasing circuit, a supply voltage to the CMOS inverter, wherein at least one transistor arrangement of the biasing circuit and the CMOS inverter are interconnected via back gates of respective transistors,
    providing (602), by a control circuit, a bias voltage to the interconnected back gates when the supply voltage reaches to a threshold value, and
    controlling (603), together by the biasing circuit and the control circuit, the transconductance of the CMOS inverter.

13. The method according to claim 12,
    wherein the method further comprises maintaining, by the control circuit, the supply voltage to the CMOS inverter when the supply voltage is higher than the threshold value.

14. The method according to claim 12 or 13,
    wherein the method further comprises:

    providing, by the biasing circuit, the supply voltage ranging from a predefined minimum value to the threshold value, and
    providing, by the control circuit, the bias voltage to the interconnected back gates ranging from zero to a supply voltage of the biasing circuit.

15. The method according to claim 14,
    wherein the method further comprises:

    controlling, by the transistor arrangement, the transconductance of the CMOS inverter for the supply voltage ranging from the predefined minimum value to the threshold value, and
    controlling, by the transistor arrangement, the transconductance of the CMOS inverter for the bias voltage to the interconnected back gates ranging from zero to the supply voltage of the biasing circuit.

100

105

$V_{bg}$

BIAS
102

CTRL
103

$V_d$

$V_t$

104

INV
101

Fig. 1

200

Fig. 2

Fig. 3A

Fig. 3B

Fig. 4

Fig. 5

600

providing, by a biasing circuit, a supply voltage to a
CMOS inverter, wherein at least one transistor
arrangement of the biasing circuit and the
CMOS inverter are interconnected via
back gates of respective transistors

601

providing, by a control circuit, a bias voltage to the
interconnected back gates when the supply voltage
reaches to a threshold value

602

controlling, together by the biasing circuit and the
control circuit, the transconductance of the
CMOS inverter

603

# Fig. 6

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YUSUKE TSUGITA ET AL: "An On-Chip PVT Compensation Technique with Current Monitoring Circuit for Low-Voltage CMOS Digital LSIs", IEICE TRANSACTIONS ON ELECTRONICS, INSTITUTE OF ELECTRONICS, TOKYO, JP, vol. E93C, no. 6, 1 June 2010 (2010-06-01), pages 835-841, XP001557247, ISSN: 0916-8524, DOI: 10.1587/TRANSELE.E93.C.835 | 1,2,12, 13 | INV. H03F1/02 H03F3/30 H03F1/30 H03F1/32 H03K19/0185 G05F3/20 |
| A | * page 835, left-hand column, line 16 – page 840, right-hand column, line 21; figures 1-10 * | 3-11,14, 15 | |
| A | US 2017/324385 A1 (MCKAY THOMAS G [US]) 9 November 2017 (2017-11-09) * paragraphs [0002] – [0075]; figures 1-12 * | 1-15 | |
| A | US 2008/218265 A1 (MURDEN FRANKLIN M [US] ET AL) 11 September 2008 (2008-09-11) * paragraphs [0004] – [0058]; figures 1-4B * | 1-15 | TECHNICAL FIELDS SEARCHED (IPC) H03F H03K G05F |

The present search report has been drawn up for all claims

| Place of search | Date of completion of the search | Examiner |
|---|---|---|
| The Hague | 11 May 2024 | Fedi, Giulio |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 21 9084

This annex lists the patent family members relating to the patent documents cited in the above-mentioned European search report.
The members are as contained in the European Patent Office EDP file on
The European Patent Office is in no way liable for these particulars which are merely given for the purpose of information.

11-05-2024

| Patent document cited in search report | | Publication date | Patent family member(s) | | Publication date |
|---|---|---|---|---|---|
| US 2017324385 | A1 | 09-11-2017 | CN | 107452798 A | 08-12-2017 |
| | | | TW | 201812951 A | 01-04-2018 |
| | | | US | 2017324385 A1 | 09-11-2017 |
| US 2008218265 | A1 | 11-09-2008 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **JANSEN et al.** Complementary constant-gm biasing of Nauta-transconductors in low-power Gm-C filters to +/-2% accuracy over temperature. *2012 Proceedings of the ESSCIRC*, 2013, 466-469